# EUROPEAN PATENT SPECIFICATION

(11) **EP 2 129 201 B1**
(45) Date of publication and mention of the grant of the patent: **12.04.2017**
(21) Application number: 08711655.4
(22) Date of filing: 20.02.2008
(51) Int. Cl.: H05K 3/46

(54) **MULTILAYER WIRING SUBSTRATE**
MEHRSCHICHTIGES SCHALTUNGSSUBSTRAT
SUBSTRAT DE CÂBLAGE MULTICOUCHE

(30) Priority: 01.03.2007 JP 2007052114
(43) Date of publication of application: 02.12.2009
(73) Proprietor: Murata Manufacturing Co. Ltd., Nagaokakyo-shi, Kyoto 617-8555 (JP)
(72) Inventor: NOMIYA, Masato, Nagaokakyo-shi Kyoto 617-8555 (JP)
(74) Representative: Schenk, Markus
(86) International application number: PCT/JP2008/052849
(87) International publication number: WO 2008/108172

(56) References cited:
- JP-A- 2001 160 681
- US-A- 4 464 420
- US-A- 4 641 425
- US-A- 4 910 643

## Description

### Technical Field

The present invention relates to a multilayer wiring board and, in particular, to a multilayer wiring board including base material layers and constrained layers that are alternately stacked.

### Background Art

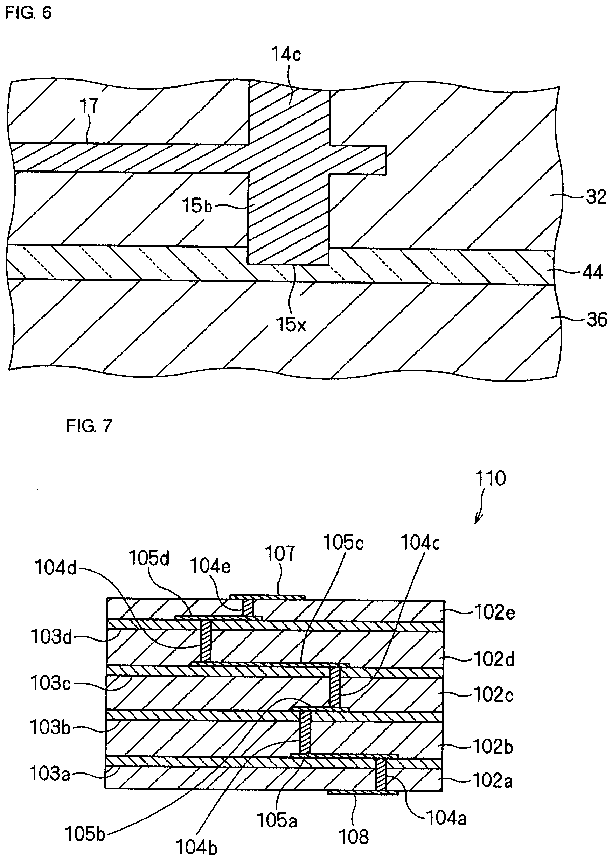

In existing technology, as illustrated by a cross-sectional view in Fig. 7, a multilayer wiring board 110 has been produced by stacking and pressing constrained layers 103a to 103d, each sandwiched between neighboring ones of the glass ceramic green sheet groups 102a to 102e each consisting of one layer or more. The glass ceramic green sheet groups 102a to 102e serve as basic material layers. The constrained layers 103a to 103d are formed of an inorganic composition that is not sintered under a firing condition of the glass ceramic green sheet groups 102a to 102e. A conductor pattern serving as one of internal electrodes 105a to 105d or one of external electrodes 107 and 108 is formed on a surface of one of the glass ceramic green sheet groups 102a to 102e and the constrained layers 103a to 103d. Through-holes that pass through the glass ceramic green sheet groups 102a to 102e are filled with conductive materials serving as via-hole conductors 104a to 104e, respectively. Subsequently, the glass ceramic green sheet groups 102a to 102e are fired. In the multilayer wiring board 110 having such a structure, the constrained layers 103a to 103d negligibly contract when being fired. Accordingly, contraction of the glass ceramic green sheet groups 102a to 102e in the surface direction is constrained by the constrained layers 103a to 103d. Consequently, separation and cracking occurring at the interfaces between the glass ceramic green sheets can be prevented (refer to, for example, Patent Document 1).

[Patent Document 1] Japanese Unexamined Patent Application Publication No. 2000-315864

### Disclosure of Invention

### Problems to be Solved by the Invention

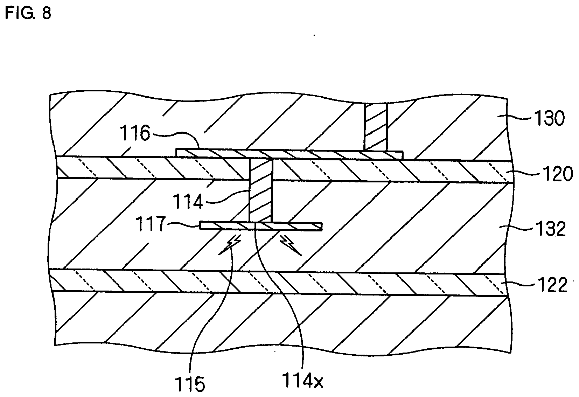

In the multilayer wiring board having such a structure, for example, as illustrated by an enlarged cross-sectional view of a main portion shown in Fig. 8, when a conductor pattern 116 is disposed on a surface of a constrained layer 120 or a basic material layer 130 and a wiring electrode 117 used for required connection is disposed in a basic material layer 132 (in the middle of the basic material layer 132) located between constrained layers 120 and 122 and if one end of a via-hole conductor 114 is connected to the wiring electrode 117, cracking 115 may occur in the basic material layer 132 in the vicinity of an end 114x of the via-hole conductor 114, that is, in the vicinity of a connection portion between the via-hole conductor 114 and the wiring electrode 117.

The cracking 115 occurs because, although contraction of portions of the basic material layer 132 in contact with the constrained layers 120 and 122 in the surface direction is sufficiently prevented during a firing process, portions remote from the constrained layers 120 and 122 are not sufficiently constrained by the constrained layers 120 and 122. Accordingly, the portions remote from the constrained layers 120 and 122 also contract in the surface direction. That is, when the via-hole conductor 114 is disposed in the basic material layer 132 and if the via-hole conductor 114 extends to the middle of the basic material layer 132, a complicated contraction force that pulls the basic material layer 132 is exerted against a portion in the vicinity of the end 114x of the via-hole conductor 114. As a result, cracking starting from the end 114x of the via-hole conductor 114 occurs in the vicinity of the wiring electrode 117. The cracking occurring in the vicinity of the wiring electrode 117 decreases the reliability of wiring of the multilayer wiring board. If the wiring electrode 117 is not disposed in the basic layer in order to prevent the occurrence of cracking, the wiring efficiency of the multilayer wiring board decreases.

US-A-4,910,643 describes a thick film, multi-layer interconnected circuit board which includes a substrate of an electrical insulating material which will withstand high temperatures, such as alumina, having over a surface thereof a plurality of stacked layers of a glass dielectric. Between each pair of dielectric layers is a thick film conductor layer. The dielectric layers have openings or vias therethrough which are filled with a conductive material which makes electrical contact with the adjacent conductive layers. A contact pad is over the topmost dielectric layer and is electrically connected to a via conductor material in the topmost dielectric layer. The contact pad is of a thick film conductive material which is a layer of glass having particles of a conductive material, such as a noble metal or mixture of noble metals, dispersed therein. A bonding layer is between the contact pad and the topmost dielectric layer and is bonded to both. The bonding layer is of a mixture of the glass of the dielectric layers and the thick film conductive material of the contact pad.

JP 2001 160 681 A which is considered to represent the closest prior art discloses a multilayer wiring board with basic material layers and constrained layers alternately stacked. A via connects to an intermediate conductor pattern disposed inside the basic material and further through the constrained layer so as to connect to a conductor pattern on the constrained layer.

Accordingly, it is an object of the present invention to provide a multilayer wiring board capable of preventing a decrease in the reliability of wiring caused by cracking even when a conductor pattern and a via-hole conductor disposed inside a basic material layer located between constrained layers are connected to each other.

This object is achieved by a multilayer wiring board of claim 1.

To solve the above-described problem, the present invention provides a multilayer wiring board having the following structure.

A multilayer wiring board includes (a) at least one basic material layer and at least one constrained layer that are alternately stacked, (b) a conductor pattern disposed on or inside the basic material layer or the constrained layer, where the conductor pattern extends in a surface direction in which the basic material layer and the constrained layer extend, and (c) a via-hole conductor extending inside at least the basic material layer in a direction in which the basic material layer and the constrained layer are stacked, where the via-hole conductor is connected to the conductor pattern. The via-hole conductor includes a via body and an extended portion, the via body is connected to an intermediate conductor pattern disposed inside the basic material layer among the conductor patterns, and the extended portion is formed by extending the via body in a direction towards the constrained layer and away from the via body, and the extended portion is connected to the intermediate conductor pattern.

In existing structure, one end of the via-hole conductor connected to the intermediate conductor pattern disposed inside the basic material layer is extended to the intermediate conductor pattern so that a via body is formed. Accordingly, the end of the via-hole conductor terminates at a position (a middle position) inside the basic material layer (at the middle position of the basic material layer). However, in the above-described structure, an extended portion is formed so that the via-hole conductor extends completely through the basic material layer and reaches the constrained layer. The extended portion of the via-hole conductor allows two via-hole conductor portions to be disposed on either side of the intermediate conductor pattern in the basic material layer. Accordingly, when being fired, the contraction behaviors of the ceramic green sheet that forms the basic material layer on either side of the intermediate conductor pattern can be made substantially the same. Thus, the difference between the contraction behaviors can be reduced. As a result, the occurrence of cracking in the vicinity of a connection portion between the via-hole conductor and the intermediate conductor pattern can be prevented.

Preferably, the extended portion of the via-hole conductor is in contact with the constrained layer.

If the extended portion of the via-hole conductor is in contact with the constrained layer, the extended portion is also supported by the constrained layer. Accordingly, contraction of the extended portion in the plane direction can be constrained. As a result, the occurrence of cracking starting from the extended portion can be prevented.

More specifically, the multilayer wiring board can be formed so as to have the following various structures.

Preferably, the extended portion of the via-hole conductor extends completely through the constrained layer.

In such a case, the position of the via-hole conductor can be reliably maintained by the constrained layer. Thus, a precision-made multilayer wiring board can be provided.

Preferably, an end surface of the extended portion of the via-hole conductor is in contact with the constrained layer.

In such a case, the distance between the intermediate conductor pattern and the constrained layer can be maintained by the extended portion of the via-hole conductor. Accordingly, a precision-made multilayer wiring board can be produced. In particular, if a surface of the basic material layer having the via-hole conductor formed therein and the end surface of the extended portion of the via-hole conductor are coplanar, the structure of the constrained layer can be simplified.

Preferably, the extended portion of the via-hole conductor is formed so as to be coaxial with the via body.

In such a case, the contraction force can be evenly exerted against the two portions on either side of the intermediate conductor pattern. Accordingly, the occurrence of cracking can be easily prevented.

In addition, preferably, the diameter of the extended portion of the via-hole conductor is the same as the diameter of the via body.

In such a case, the difference between the contraction behaviors on either side of the intermediate conductor pattern is negligible. Thus, the occurrence of cracking can be easily prevented.

Preferably, the thickness of the basic material layer having the intermediate conductor pattern therein is greater than the thickness of the other basic material.

For example, when the basic material layer having the intermediate conductor pattern therein is produced by bonding two ceramic green sheets separated by the intermediate conductor pattern serving as a boundary, the thickness of the basic material layer having the intermediate conductor pattern therein is greater than the thickness of the other sheet produced from only one ceramic green sheet group. Note that a ceramic green sheet group is formed from a single ceramic green sheet or is formed by stacking and pressing a plurality of ceramic green sheets.

As in the above-described structure, if one end of the via-hole conductor extends through the basic material layer, the contraction behaviors on either side of the intermediate conductor pattern can be made substantially the same. Accordingly, the occurrence of cracking in the vicinity of a connection portion between the via-hole conductor and the intermediate conductor pattern can be prevented. Advantages

According to the present invention, even when a conductor pattern disposed inside a basic material layer (in the middle of the basic material layer) is connected to a via-hole conductor, the occurrence of cracking in the vicinity of a connection portion between the via-hole conductor and the conductor pattern can be prevented. As a result, the wiring efficiency of the multilayer wiring board can be increased.

### Brief Description of Drawings

[Fig. 1] Fig. 1 is a cross-sectional view of a multilayer wiring board having components mounted thereon (a first embodiment).
[Fig. 2] Fig. 2 is a cross-sectional view illustrating steps of manufacturing the multilayer wiring board (the first embodiment).
[Fig. 3] Fig. 3 is a cross-sectional view of the multilayer wiring board (the first embodiment).
[Fig. 4] Fig. 4 is an enlarged cross-sectional view of a main portion of the multilayer wiring board (the first embodiment).
[Fig. 5] Fig. 5 is an enlarged cross-sectional view of a main portion of a multilayer wiring board (a second embodiment).
[Fig. 6] Fig. 6 is an enlarged cross-sectional view of a main portion of a multilayer wiring board (a third embodiment).
[Fig. 7] Fig. 7 is a cross-sectional view of a multilayer wiring board (an existing example).
[Fig. 8] Fig. 8 is an enlarged cross-sectional view of a main portion of the multilayer wiring board (the existing example).

### Reference Numerals

- 10: multilayer wiring board
- 14: via-hole conductor
- 15: extended portion
- 15x: end surface
- 17: intermediate conductor pattern
- 18: via body
- 30, 32, 36: basic material layer
- 40, 42, 44, 46: constrained layer

### Best Modes for Carrying Out the Invention

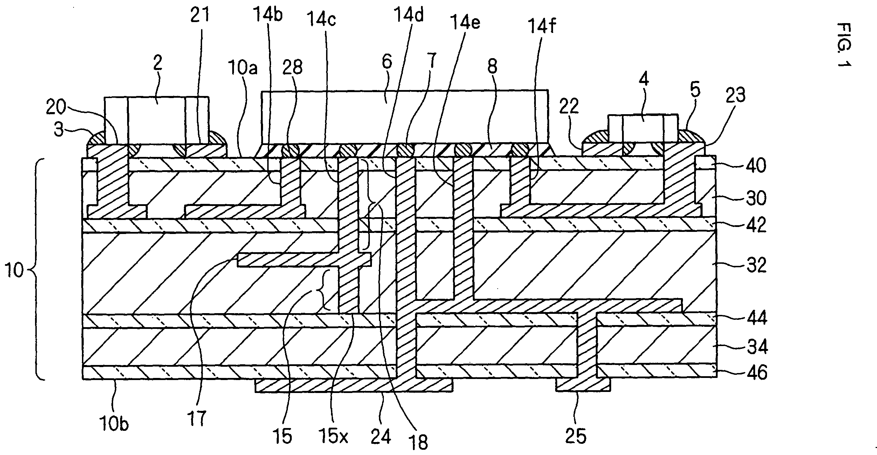

Various embodiments of the present invention are described below with reference to Figs. 1 to 6.

### First Embodiment

A multilayer wiring board according to a first embodiment is described next with reference to Figs. 1 to 4.

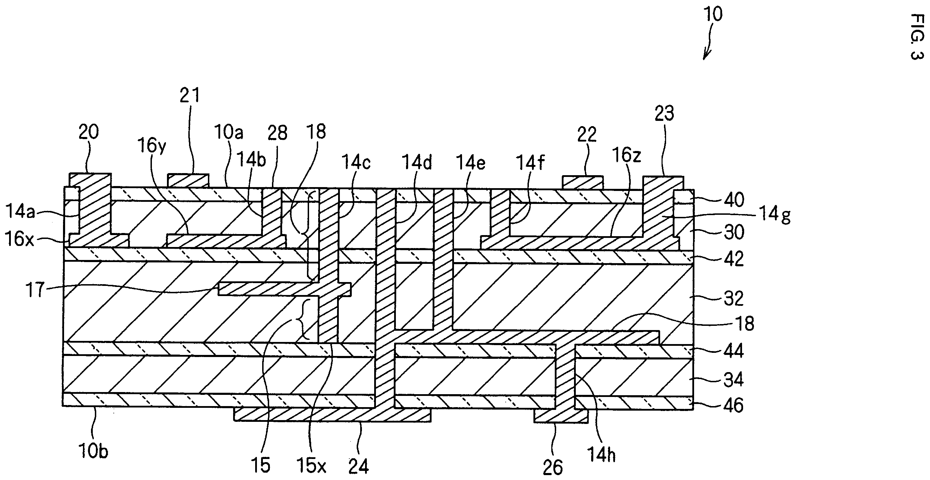

As shown by a cross-sectional view of Fig. 3, a multilayer wiring board 10 includes alternately stacked basic material layers 30, 32, and 34 and constrained layers 40, 42, 44, and 46. Conductor patterns 16x, 16y, 16z, and 18 and conductor patterns 20 to 26 that extend in the surface direction of the basic material layers 30, 32, and 34 and the constrained layers 40, 42, 44, and 46 are formed on surfaces of the basic material layers 30, 32, and 34 or surfaces of the constrained layers 40, 42, 44, and 46. In addition, a conductor pattern (an intermediate conductor pattern) 17 is disposed inside the basic material layer 32.

Ends of via-hole conductors 14a to 14h are connected to the conductor patterns 16x, 16y, 16z, 18, 20 and the conductor patterns 23 to 26. The via-hole conductors 14a to 14h extend in a direction in which the basic material layers 30, 32, and 34 and the constrained layers 40, 42, 44, and 46 are stacked. In particular, the via-hole conductor 14c is connected to the intermediate conductor pattern 17 disposed inside the basic material layer 32. An end of a via body 18 of the via-hole conductor 14c connected to the intermediate conductor pattern 17 is extended towards the constrained layer 44. Thus, an extended portion 15 that passes beyond the intermediate conductor pattern 17 and reaches the constrained layer 44 is formed.

By forming the extended portion 15 of the via-hole conductor 14c, the basic material layer 32 includes the via body 18 and the extended portion 15 of the via-hole conductor 14c disposed on either side of the intermediate conductor pattern 17. Accordingly, when being fired, contraction behaviors of two portions of the ceramic green sheet that forms the basic material layer 32 on either side of the intermediate conductor pattern 17 are substantially the same and, therefore, the difference between the contraction behaviors is decreased. Consequently, cracking occurring at a connection portion of the via-hole conductor 14c and the intermediate conductor pattern 17 can be prevented.

The extended portion 15 is coaxial with the via body 18. In addition, the extended portion 15 and the via body 18 have the same diameter. If the extended portion 15 is formed so as to be coaxial with the via body 18, a contraction force can be evenly propagated to the both sides of the intermediate conductor pattern 17 when the ceramic green sheet is fired. Accordingly, the occurrence of cracking is further easily prevented. In addition, if the extended portion 15 is formed so as to have a diameter the same as that of the via body 18, the difference between the contraction behaviors on either side of the intermediate conductor pattern 17 is negligible when the ceramic green sheet is fired. Accordingly, the occurrence of cracking is further easily prevented.

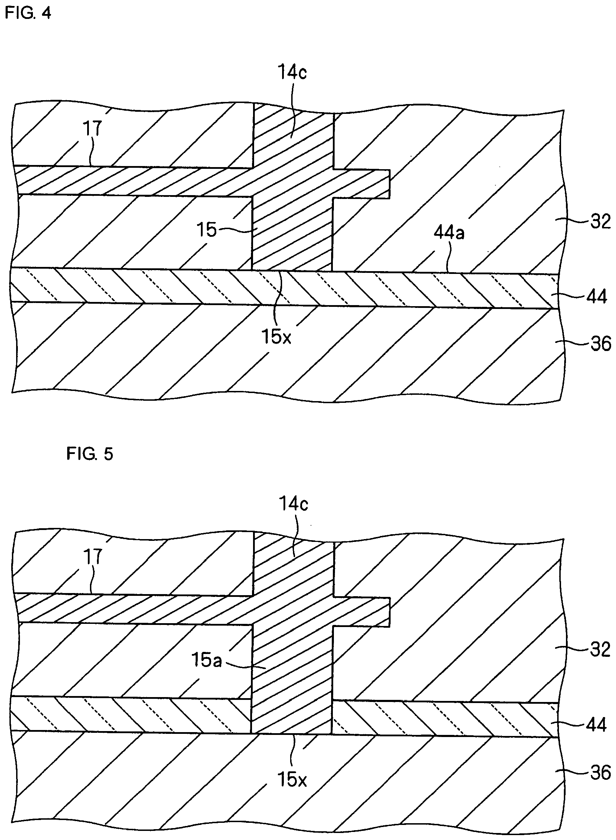

As shown by a cross-sectional view of a main portion in Fig. 4, an end surface 15x of the extended portion 15 is in contact with a surface 44a of the constrained layer 44 adjacent to the basic material layer 32 having the via-hole conductor 14c formed therein.

If the end surface 15x of the extended portion 15 of the via-hole conductor 14c is in contact with a surface 44a of the constrained layer 44, the extended portion 15 of the via-hole conductor 14c is also supported by the constrained layer 44. Accordingly, contraction of the extended portion 15 in the surface direction can be constrained. Consequently, the occurrence of cracking starting from the extended portion 15 can be prevented. Since a surface of the basic material layer 32 having the via-hole conductor 14c formed therein and the end surface 15x of the extended portion 15 of the via-hole conductor 14c are coplanar, the structure of the constrained layer 44 can be simplified.

The thickness of the basic material layer 32 having the intermediate conductor pattern 17 formed therein may be greater than the thickness of each of the other basic material layers 30 and 34. For example, when the basic material layer 32 having the intermediate conductor pattern 17 formed therein is generated by bonding two ceramic green sheet groups separated by the intermediate conductor pattern 17 serving as a boundary, the thickness of the basic material layer having the intermediate conductor pattern 17 formed therein tends to be greater than the thickness of each of the other basic material layers 30 and 34 each being formed from a single ceramic green sheet group.

As shown by the cross-sectional view of Fig. 1, chip electronic components 2 and 4 are joined, using solders 3 and 5, to the conductor patterns 20 to 23 exposed at a top surface 10a of the multilayer wiring board 10. In addition, an IC chip 6 is flip-chip bonded, using solder balls 7, to end surfaces of the via-hole conductors 14b to 14f exposed at the top surface 10a of the multilayer wiring board 10. An underfill resin 8 is filled between the IC chip 6 and the top surface 10a of the multilayer wiring board 10.

The conductor patterns 24 and 25 exposed at a bottom surface 10b of the multilayer wiring board 10 are used as connection terminals that connect the multilayer wiring board 10 with another multilayer wiring board (not shown).

Each of the basic material layers 30, 32, and 34 is formed by firing one or more ceramic green sheets including a first ceramic material. The basic material layers 30, 32, and 34 determine the board characteristic of the multilayer wiring board 10. Each of the constrained layers 40, 42, 44, and 46 is formed by firing one or more ceramic green sheets including a second ceramic material.

It is desirable that the thickness of each of the basic material layers 30, 32, and 34 range from 8 µm to 100 µm after the green sheets is sintered. The thickness of each of the basic material layers 30, 32, and 34 is not limited to that range. However, it is desirable that the thickness of each of the basic material layers 30, 32, and 34 be less than or equal to a maximum thickness of each of the constrained layers 40, 42, 44, and 46 that can be constrained during firing. The thicknesses of the basic material layers 30, 32, and 34 may differ from one another.

A ceramic material part (e.g., a glass component) of which is impregnated in the constrained layers 40, 42, 44, and 46 during firing is used as the first ceramic material. In addition, it is desirable that the first ceramic material be a low-temperature co-fired ceramic (LTCC) that can be fired at a relatively low temperature, for example, a temperature lower than or equal to 1050°C. More specifically, glass ceramic that is a mixture of alumina and borosilicate-based glass or Ba-Al-Si-O-based ceramic that generates a glass component during firing can be used as the first ceramic material.

The second ceramic material is adhered to part of the first ceramic material that interpenetrates from the basic material layers 30, 32, and 34. Accordingly, the constrained layers 40, 42, 44, and 46 are solidified. In addition, the basic material layers 30, 32, and 34 adjacent to the constrained layers 40, 42, 44, and 46 are joined.

Alumina or zirconia is used as the second ceramic material. The constrained layers 40, 42, 44, and 46 include the unsintered second ceramic material having a sintering temperature higher than that of the first ceramic material. Accordingly, during firing, the constrained layers 40, 42, 44, and 46 restricts contraction thereof in the surface direction with respect to the basic material layers 30, 32, and 34. In addition, as noted above, the constrained layers 40, 42, 44, and 46 are adhered and joined when part of the first ceramic material interpenetrates. Accordingly, it is desirable that the thickness of each of the constrained layers 40, 42, 44, and 46 be about 1 µm to about 10 µm after being sintered although, precisely speaking, the thickness depends on the states of the constrained layers 40, 42, 44, and 46, a desired force of constraint, and a firing condition.

The material of conductor portions of the conductor patterns and the via-hole conductors can consist primarily of a conductive component that can be sintered at the same time as the basic material layers 30, 32, and 34 are sintered. For example, a widely known material can be used as the material of conductor portions of the conductor patterns and the via-hole conductors. More specifically, Cu, Ag, Ni, Pd, an oxide thereof, or an alloy component thereof can be used. In the present embodiment, the conductor portions consisting primarily of Cu are formed.

A method for manufacturing the multilayer wiring board 10 is described next.

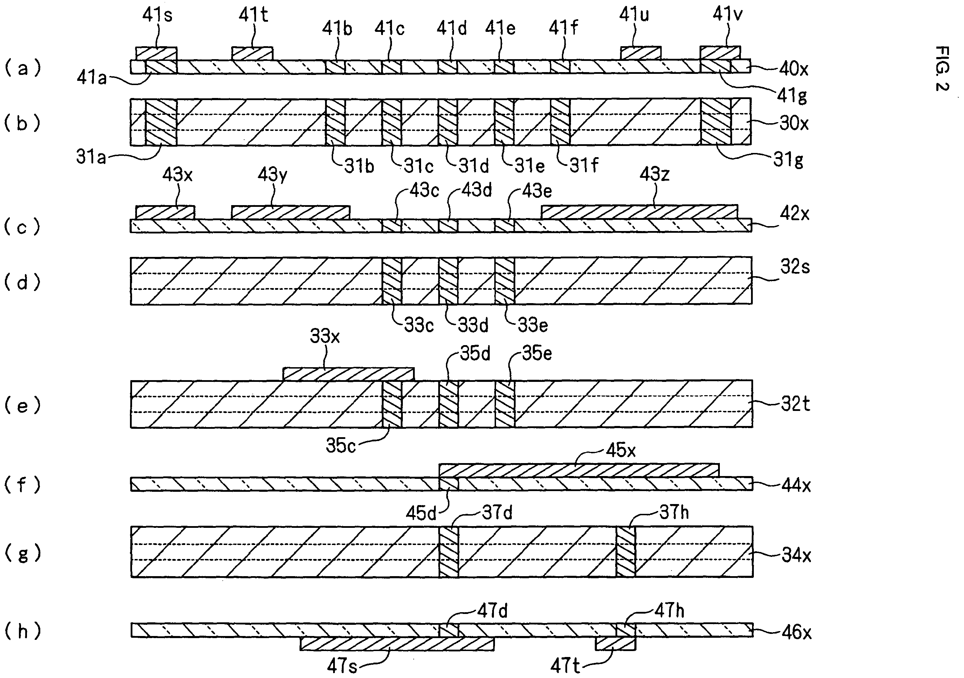

As schematically shown by the cross-sectional view in Fig. 2, the following ceramic green sheet groups are prepared: a ceramic green sheet group 30x corresponding to the basic material layer 30 shown in Fig. 1, ceramic green sheet groups 32s and 32t corresponding to the basic material layer 32 shown in Fig. 1, a ceramic green sheet group 34x corresponding to the basic material layer 34 shown in Fig. 1, and ceramic green sheet groups 40x, 42x, 44x, and 46x corresponding to the constrained layers 40, 42, 44, and 46 shown in Fig. 1, respectively. For the basic material layer 32, the two ceramic green sheet groups 32s and 32t are prepared. For each of the other layers, a single ceramic green sheet group is prepared. Each of the ceramic green sheet groups 30x, 32s, 32t, 34x, 40x, 42x, 44x, and 46x is formed by pressing a single ceramic green sheet or stacking and pressing a plurality of ceramic green sheets. For example, one side of each of the ceramic green sheet groups 30x, 32s, 32t, 34x, 40x, 42x, 44x, and 46x is supported by a carrier film (not shown).

A through-hole is formed in each of the ceramic green sheet groups 30x, 32s, 32t, 34x, 40x, 42x, 44x, and 46x by using, for example, a die. Thereafter, a conductive paste is filled with the through-holes. In this way, via-hole conductors 31a to 31g, via-hole conductors 33c to 33e, via-hole conductors 35c to 35e, via-hole conductors 37d and 37h, via-hole conductors 41a to 41g, via-hole conductors 43c to 43e, a via-hole conductor 45d, and via-hole conductors 47d and 47h are formed. In addition, conductive paste is printed on a surface of each of the ceramic green sheet groups 32t, 40x, 42x, 44x, and 46x so that a conductor pattern 33x, conductor patterns 41s to 41v, conductor patterns 43x to 43z, a conductor pattern 46x, and conductor patterns 47s and 47t are formed, respectively.

Subsequently, the generated ceramic green sheet groups 30x, 32s, 32t, and 34x and the generated ceramic green sheet groups 40x, 42x, 44x, and 46x are stacked and pressed in predetermined orders and in predetermined directions. Thus, a ceramic green sheet compact is generated.

At that time, the conductor pattern 33x serving as a wiring electrode is disposed between the ceramic green sheet groups 32s and 32t used for forming the basic material layer 32. If, for the conductor pattern 33x serving as the intermediate conductor pattern 17 (refer to Figs. 1 and 3), the via-hole conductor 33c to be connected to the conductor pattern 33x is provided in the ceramic green sheet group 32s, the via-hole conductor 33c extending to the neighboring ceramic green sheet group 44x is also provided in a portion located at a coaxial position when the ceramic green sheet group 32s is joined to the ceramic green sheet group 32t.

Note that, in place of preparing ceramic green sheet groups, stacking the ceramic green sheet groups, and forming a ceramic green sheet compact, the ceramic green sheets may be pressed in an appropriate order so that a ceramic green sheet compact is formed.

Subsequently, the ceramic green sheet compact is fired in a predetermined atmosphere at a predetermined temperature. In this way, the multilayer wiring board 10 as shown in Fig. 3 is achieved. During firing, in the ceramic green sheet compact, the basic material layers 30, 32, and 34 tend to contract. However, the constrained layers 40, 42, 44, and 46 act to constrain the contraction of the basic material layers 30, 32, and 34. Thus, the multilayer wiring board 10 having high precision dimensions can be manufactured.

In order to increase the integrity with a wall surface, conductive paste used for the via-hole conductors 31a to 31g, the via-hole conductors 33c to 33e, the via-hole conductors 35c to 35e, the via-hole conductors 37d and 37h, the via-hole conductors 41a to 41g, the via-hole conductors 43c to 43e, the via-hole conductor 45d, and the via-hole conductors 47d and 47h may include glass of an amount that does not impair the conductivity and the surface treatment. However, the composition of the conductive paste is not limited to the above-described composition if the composition does not reduce the effect of the present invention.

The firing atmosphere is appropriately changed in accordance with the type of the first ceramic material and the type of conductive particles contained in a conductive paste film.

In a particular example, a Ba-Al-Si-O-based ceramic material was used for the first ceramic material of the basic material layers 30, 32, and 34. Alumina was used for the second ceramic material of the constrained layers 40, 42, 44, and 46. In addition, the thickness of each of the sintered basic material layers 30 and 34 was set to 20 µm. The thickness of the sintered basic material layer 32 was set to 40 µm. The thickness of each of the sintered constrained layers 40, 42, 44, and 46 was set to 3 µm. Note that the thickness of the basic material layer 32 may be the same as that of the basic material layers 30 and 34 if a desired electrical characteristic and mechanical strength can be obtained.

As a comparative example, a multilayer wiring board similar to the particular example except that the via-hole conductor 14c did not have the extended portion 15 was produced.

TABLE 1 shows the cracking occurrence rates of the particular example and the comparative example. The number of samples is 100 for both examples.

**TABLE 1**

| | Cracking Occurrence Rate |
|---|---|
| Particular Example | 0% |
| Comparative Example | 90% |

As can be seen from the above-described result, cracking of the basic material layer 32 can be prevented even when the intermediate conductor pattern 17 is connected to the via-hole conductor 14c disposed inside the basic material layer 32 (in the middle of the basic material layer 32). As a result, the multilayer wiring board 10 having an excellent wiring efficiency can be achieved.

### Second Embodiment

A multilayer wiring board according to a second embodiment is described next with reference to Fig. 5. According to the second embodiment, a multilayer wiring board has a structure substantially the same as that of the multilayer wiring board 10 of the first embodiment. In the following description, different points are mainly described. The same numbering will be used in the following description as was utilized above in describing the first embodiment.

As indicated by the enlarged view of a main portion in Fig. 5, unlike the first embodiment illustrated in Fig. 3, the end surface 15x of an extended portion 15a of the via-hole conductor 14c is not in contact with the constrained layer 44. Instead, the end surface 15x passes through the constrained layer 44 and is in contact with a basic material layer 36 located on the other surface of the constrained layer 44.

In this case, the occurrence of cracking in the intermediate conductor pattern 17 can be prevented. In addition, the occurrence of cracking starting from the extended portion 15a of the via-hole conductor 14c can be prevented. As a result, the reliability of the basic material layer 36 can be increased.

### Third Embodiment

Like the second embodiment, as shown in Fig. 6, a multilayer wiring board of a third embodiment has a structure similar to that of the first embodiment.

As indicated by the enlarged view of a main portion in Fig. 6, an extended portion 15b of the via-hole conductor 14c extends to the middle point of the constrained layer 44. Such a structure can be generated by, for example, forming the constrained layer 44 using a plurality of green sheets and stacking the green sheet including a through-hole filled with a conductive material and the green sheet including no through-hole. The through-hole filled with a conductive material corresponds to the extended portion 15b of the via-hole conductor 14c.

In this case, the occurrence of cracking in the intermediate conductor pattern 17 can be prevented. In addition, the occurrence of cracking starting from the extended portion 15b of the via-hole conductor 14c can be prevented. As a result, the reliability of the basic material layer 36 can be increased.

### Summary

As described above, the via-hole conductor 14c to be connected with the intermediate conductor pattern 17 disposed inside the basic material layer 32 is extended beyond the intermediate conductor pattern 17 so that the extended portion 15, 15a, 15b, or 15c is generated. The extended portions 15, 15a, 15b, and 15c do not have electrical conductivity. However, when being fired, contraction behaviors of two portions of the ceramic green sheet that forms the basic material layer 32 on either side of the intermediate conductor pattern 17 can be made substantially the same and, therefore, cracking occurring at a connection portion of the intermediate conductor pattern and the via-hole conductor 14c and in the vicinity thereof can be prevented. As a result, the wiring efficiency of the multilayer wiring board can be increased.

It should be noted that the present invention is not limited to the above-described embodiments. Many variations thereon can be made.

## Claims

1. A multilayer wiring board comprising:
at least one basic material layer (30, 32, 34) including a first ceramic material and at least one constrained layer (40, 42, 44, 46) including a second ceramic material that are alternately stacked, the constrained layer (40, 42, 44, 46) restricting contraction thereof in a surface direction with respect to the basic material layer (30, 32, 34);
a conductor pattern (16x-z, 19, 20-25) disposed on the basic material layer (30, 32, 34) or the constrained layer (40, 42, 44, 46), the conductor pattern (16x-z, 19, 20-25) extending in the surface direction in which the basic material layer (30, 32, 34) and the constrained layer (40, 42, 44, 46) extend;
a via-hole conductor (14c) extending inside at least the basic material layer (30, 32, 34) in a direction in which the basic material layer (30, 32, 34) and the constrained layer (40, 42, 44, 46) are stacked, the via-hole conductor (14c) being connected to the conductor pattern (16x-z); and
an intermediate conductor pattern (17) disposed inside the basic material layer (30, 32, 34),
wherein the via-hole conductor (14c) is connected to the intermediate conductor pattern (17) and includes a via body (18) and an extended portion (15) disposed on either side of the intermediate conductor pattern (17),
wherein the via body (18) is connected to the intermediate conductor pattern (17),
wherein the extended portion (15) is formed by extending the via body (18) in a direction towards the constrained layer (40, 42, 44, 46) and away from the via body (18), and a first end of the extended portion (15) is connected to the intermediate conductor pattern (17), and
wherein a second end of the extended portion (15) of the via-hole conductor (14c) is in contact with the constrained layer (40, 42, 44, 46),
**characterized in that**
an end surface (15x) of the extended portion (15) is in contact with a surface (44a) of the constrained layer (44) adjacent to the basic material layer (32) having the via-hole conductor (14c) provided therein.

2. The multilayer wiring board according to Claim 1, wherein the extended portion (15) of the via-hole conductor (14c) is formed so as to be coaxial with the via body (18).

3. The multilayer wiring board according to Claim 2, wherein the diameter of the extended portion (15) of the via-hole conductor (14c) is the same as the diameter of the via body (18).

4. The multilayer wiring board according to Claims 1 to 3, wherein the thickness of the basic material layer (32) having the intermediate conductor pattern (17) therein is greater than the thickness of the other basic material layers (30, 34).

## Patentansprüche

1. Eine Mehrschichtverdrahtungsplatine, die folgende Merkmale aufweist:
zumindest eine Grundmaterialschicht (30, 32, 34) einschließlich eines ersten Keramikmaterials und zumindest eine eingezwängte Schicht (40, 42, 44, 46) einschließlich eines zweiten Keramikmaterials, die abwechselnd gestapelt sind, wobei die eingezwängte Schicht (40, 42, 44, 46) eine Kontraktion derselben in einer Oberflächenrichtung in Bezug auf die Grundmaterialschicht (30, 32, 34) einschränkt;
ein Leitermuster (16x-z, 19, 20-25), das auf der Grundmaterialschicht (30, 32, 34) oder der eingezwängten Schicht (40, 42, 44, 46) angeordnet ist, wobei sich das Leitermuster (16x-z, 19, 20-25) in der Oberflächenrichtung erstreckt, in der sich die Grundmaterialschicht (30, 32, 34) und die eingezwängte Schicht (40, 42, 44, 46) erstrecken;
einen Durchgangslochleiter (14c), der sich in zumindest der Grundmaterialschicht (30, 32, 34) in einer Richtung erstreckt, in der die Grundmaterialschicht (30, 32, 34) und die eingezwängte Schicht (40, 42, 44, 46) gestapelt sind, wobei der Durchgangslochleiter (14c) mit dem Leitermuster (16x-z) verbunden ist; und
ein Zwischenleitermuster (17), das in der Grundmaterialschicht (30, 32, 34) angeordnet ist,
wobei der Durchgangslochleiter (14c) mit dem Zwischenleitermuster (17) verbunden ist und einen Durchgangskörper (18) sowie einen erweiterten Abschnitt (15) umfasst, die jeweils auf einer der beiden Seiten des Zwischenleitermusters (17) angeordnet sind,
wobei der Durchgangskörper (18) mit dem Zwischenleitermuster (17) verbunden ist,
wobei der erweiterte Abschnitt (15) durch Erweitern des Durchgangskörpers (18) in einer Richtung zu der eingezwängten Schicht (40, 42, 44, 46) hin und von dem Durchgangskörper (18) weg gebildet ist, und ein erstes Ende des erweiterten Abschnittes (15) mit dem Zwischenleitermuster (17) verbunden ist, und
wobei ein zweites Ende des erweiterten Abschnittes (15) des Durchgangslochleiters (14c) mit der eingezwängten Schicht (40, 42, 44, 46) in Kontakt steht,
**dadurch gekennzeichnet, dass**
eine Endoberfläche (15x) des erweiterten Abschnittes (15) mit einer Oberfläche (44a) der eingezwängten Schicht (44) in Kontakt steht, die zu der Grundmaterialschicht (32), in der der Durchgangslochleiter (14c) vorgesehen ist, benachbart ist.

2. Die Mehrschichtverdrahtungsplatine gemäß Anspruch 1, bei der der erweiterte Abschnitt (15) des Durchgangslochleiters (14c) dahin gehend gebildet ist, mit dem Durchgangskörper (18) koaxial zu sein.

3. Die Mehrschichtverdrahtungsplatine gemäß Anspruch 2, bei der der Durchmesser des erweiterten Abschnittes (15) des Durchgangslochleiters (14c) genauso groß ist wie der Durchmesser des Durchgangskörpers (18).

4. Die Mehrschichtverdrahtungsplatine gemäß einem der Ansprüche 1 bis 3, bei der die Dicke der Grundmaterialschicht (32), in der das Zwischenleitermuster (17) vorliegt, größer ist als die Dicke der anderen Grundmaterialschichten (30, 34).

## Revendications

1. Carte de câblage multicouche comprenant :
au moins une couche de matériau de base (30, 32, 34) comprenant un premier matériau en céramique et au moins une couche contrainte (40, 42, 44, 46) comprenant un second matériau en céramique qui sont empilées de manière alternée, la couche contrainte (40, 42, 44, 46) limitant sa contraction dans une direction de surface par rapport à la couche de matériau de base (30, 32, 34) ;
un tracé conducteur (16x-z, 19, 20-25) disposé sur la couche de matériau de base (30, 32, 34) ou la couche contrainte (40, 42, 44, 46), le tracé conducteur (16x-z, 19, 20-25) s'étendant dans la direction de surface dans laquelle la couche de matériau de base (30, 32, 34) et la couche contrainte (40, 42, 44, 46) s'étendent ;
un conducteur de trou d'interconnexion (14c) s'étendant à l'intérieur d'au moins la couche de matériau de base (30, 32, 34) dans une direction dans laquelle la couche de matériau de base (30, 32, 34) et la couche contrainte (40, 42, 44, 46) sont empilées, le conducteur de trou d'interconnexion (14c) étant raccordé au tracé conducteur (16x-z) ; et
un tracé conducteur intermédiaire (17) disposé à l'intérieur de la couche de matériau de base (30, 32, 34),
dans lequel le conducteur de trou d'interconnexion (14c) est raccordé au tracé conducteur intermédiaire (17) et comprend un corps d'interconnexion (18) et une partie étendue (15) disposée de chaque côté du tracé conducteur intermédiaire (17),
dans laquelle le corps d'interconnexion (18) est raccordé au tracé conducteur intermédiaire (17),
dans laquelle la partie étendue (15) est formée en étendant le corps d'interconnexion (18) dans une direction vers la couche contrainte (40, 42, 44, 46) et à distance du corps d'interconnexion (18), et une première extrémité de la partie étendue (15) est raccordée au tracé conducteur intermédiaire (17), et
dans laquelle une seconde extrémité de la partie étendue (15) du conducteur de trou d'interconnexion (14c) est en contact avec la couche contrainte (40, 42, 44, 46),
**caractérisée en ce que** :
une surface d'extrémité (15x) de la partie étendue (15) est en contact avec une surface (44a) de la couche contrainte (44) adjacente à la couche de matériau de base (32) ayant le conducteur de trou d'interconnexion (14c) prévu à l'intérieur de cette dernière.

2. Carte de câblage multicouche selon la revendication 1, dans laquelle la partie étendue (15) du conducteur de trou d'interconnexion (14c) est formée pour être coaxiale avec le corps d'interconnexion (18).

3. Carte de câblage multicouche selon la revendication 2, dans laquelle le diamètre de la partie étendue (15) du conducteur de trou d'interconnexion (14c) est le même que le diamètre du corps d'interconnexion (18).

4. Carte de câblage multicouche selon les revendications 1 à 3, dans laquelle l'épaisseur de la couche de matériau de base (32) ayant le tracé conducteur intermédiaire (17) à l'intérieur de cette dernière, est supérieure à l'épaisseur des autres couches de matériau de base (30, 34).
